# EUROPEAN PATENT APPLICATION

(11) **EP 1 357 656 A2**
(43) Date of publication of application: **29.10.2003**
(21) Application number: 02080306.0
(22) Date of filing: 16.12.2002
(51) Int. Cl.: H02H 3/17

(54) **Test measurement and control apparatus for a ground plant with protection of the electric plant connected thereto**

(30) Priority: 24.04.2002 IT CA20020007
(71) Applicant: Nora R & S s.r.l., 09010 Pula (CA) (IT)
(72) Inventor: Betti, Nicola, Sarroch (CA) 09018 (IT); Spanu, Matteo, 09010 Pul (CA) (IT)
(74) Representative: Mittler, Enrico

(57) **Abstract**

The present invention refers to a test, measurement and control apparatus (2, 20) of a ground plant associated to an electric plant comprising a switch (1, 10) suitable for controlling a supply line of said electric plant. The test, measurement and control apparatus provides at least two terminals (DA, D; DV, T1), of which a first terminal (DA, D) is connected to a first stake (Pi, Pd) of conducting material driven into the ground to send it a first signal (I, V) of constant value and a fixed frequency and a second terminal (DV, T) is connected to a second stake (P2) driven into the ground at a preset distance from the first stake (P1, Pd) and from the ground plant being controlled, or directly to the ground plant, to receive a second signal (I2, Vr) indicative of the state of the ground plant being controlled. Provision is made for measurement means (TC) suitable for measuring the value of said second signal (I2, Vr) and comparing it with a preset threshold.

## Description

The present invention refers to a control apparatus that carries out the constant measurement of the efficiency of a ground plant by means of an electronic control system, that commands mechanically and/or electrically a device for protection of any electrical plant connected to it.

It is known in the state of the technique in buildings, both civil and industrial, and on work sites; that there are ground plants associated to the electrical plants of said buildings to make them safe.

Nevertheless said ground plants can be not very efficient because of breakdowns in the circuits of which they are composed.

In view of the state of the technique as described above, the object of the present invention is to provide a test, measurement and control apparatus of a ground plant, that enables the efficiency to be constantly checked.

In accordance with the present invention, this object is achieved by means of a test, measurement and control apparatus of a ground plant, that presents the characteristics defined in claim 1.

The apparatus according to the invention can be used as active protection installed in any electric switchboard, as it can cause automatic operation of a switch, or an automatic magnetothermal, an automatic magnetodifferential or other interruption device connected to it intervene if the electric resistance values set by the safety and protection regulations are exceeded, or it can be used limitedly as a visual and/or acoustic signal for an anomaly of the ground plant that occurs.

The apparatus comprises a ground terminal, associated to at least one generic electric plant (for civil, industrial, work sites in general, public use, etc.) that possesses a switch suitable for controlling an electric power supply line. The switch can be activated directly and automatically by the test, measurement and control apparatus connected to it, or by a manual test button comprised in it, to test the correct operating of said apparatus.

The test, measurement and control apparatus according to the invention can also carry out an activity of protection of the electric plant as it can command the interruption of the electricity if the ground plant is not efficient enough to guarantee the safety of the same electric plant.

The apparatus of the present invention can be produced by using techniques and components of common commercial use, in the dimensions required by the technical needs, and preferably can be made in a modular apparatus with unified dimensions that can be installed by clipping onto a standardized guide of electric switchboards.

In relation to the type of electric plant to be protected, the test, measurement and control apparatus of the ground plant provides for two embodiments of the invention, which will now be described in detail, as non-limiting examples, making reference to the enclosed drawings, wherein:
Figure 1 is a front view of the test, measurement and control apparatus according to a first embodiment of the invention that provides for the use of three measuring wires;
Figure 2 is a front view of the test, measurement and control apparatus of Figure 1 connected, as an example, to a four-pole switch;
Figure 3 is an electric block diagram of the test, measurement and control apparatus of Figure 1;
Figure 4 is a front view of the test, measurement and control apparatus in accordance with a second embodiment of the invention that provides for the use of two measuring wires;
Figure 5 is a front view of the test, measurement and control apparatus of Figure 4 connected, as an example, to a single-phase switch;
Figure 6 is an electric block diagram of the test device of Figure 4;
Figure 7 is a view in perspective of the overall composition of the test, measurement and control apparatus and of the switch (differential or magnetothermal or other type) of the electric plant under control, shown disconnected one from the other.

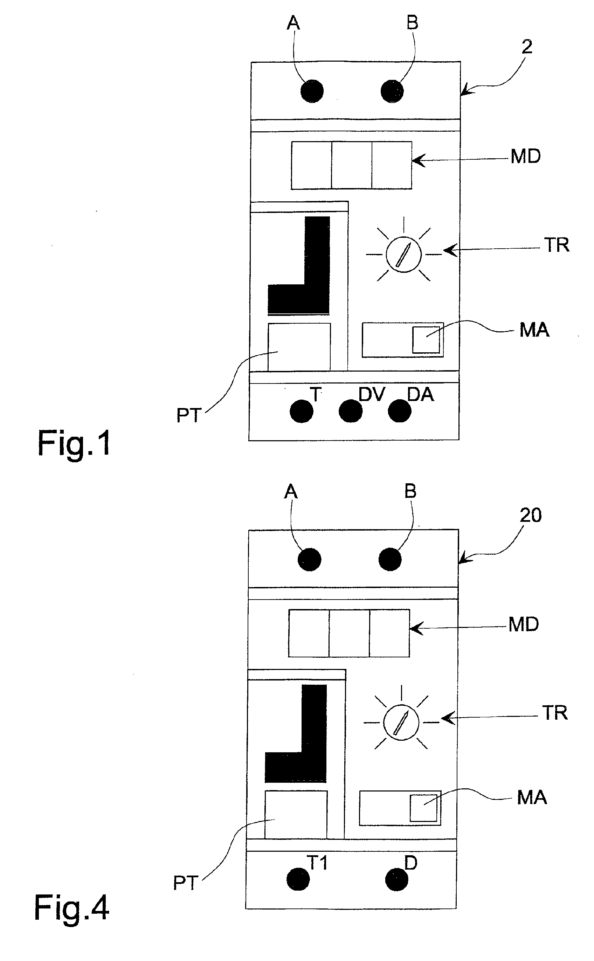

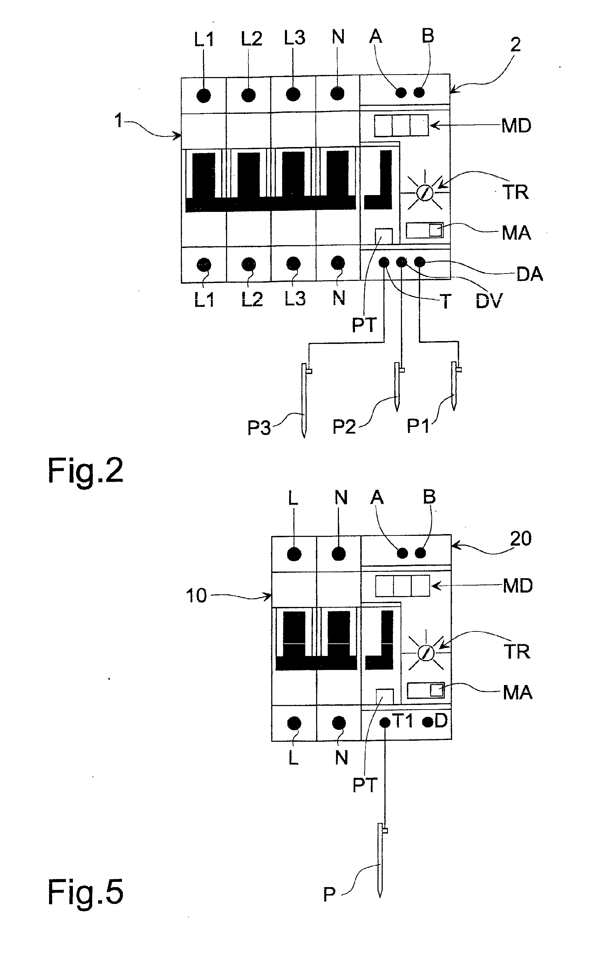

With reference to Figure 1 a test, measurement and control apparatus is shown according to a first embodiment of the invention, indicated as a whole with 2, that can be associated to a four-pole switch 1 that is part of the electric plant of a building, as shown in Figure 2.

The switch 1 can be of the magnetothermal or magnetothermal differential type, or can be constituted by a contactor, and can comprise also only the ground fault interrupter device. In the case represented in Figure 2 the switch 1 comprises three line terminals L1-L2-L3 and a neutral terminal N to connect to an electric plant with three-phase and neutral line. The switch 1 could also be only three-polar without the terminal N.

The test, measurement and control device 2 of Figure 1 is a three-wire device provided with two supply terminals A, B in alternating current, three terminals DA, DV and T that can be connected to ground as described below, an analog/digital visualizer MD, a potentiometer for adjusting the intervention threshold of the test, measurement and control apparatus, a switch MA for selecting automatic or manual opening operation the switch 1, and a test button PT.

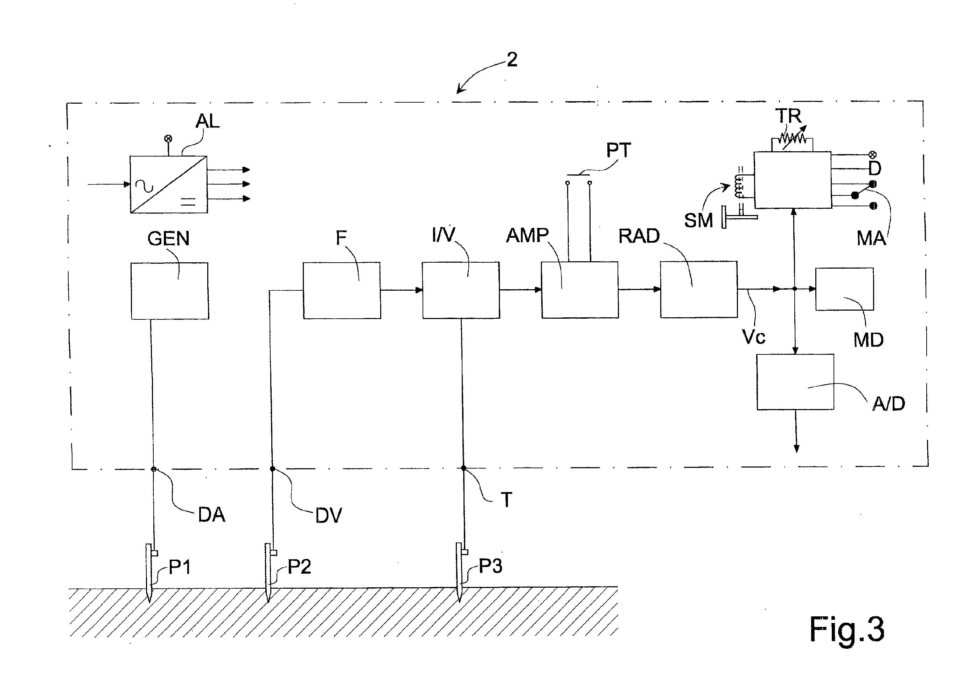

The electric block diagram of the apparatus of Figure 1 is shown in Figure 3.

In the circuit of Figure 3 a power supply AL having alternated mains voltage in input (terminals A, B in the Figures 1 and 2) supplies in output the direct current needed to supply the circuit components. The latter comprises a constant sinusoidal current generator G, having a set frequency, suitable for supplying constant current I, whose value is normally comprised between 1 and 10 mA, through the terminal DA to a metal stake P1 inserted in the ground to leak the current to the ground. The stake P1 is positioned at a depth of between 30 cm and 50 cm and at a distance of about 20 m from the ground plant of the electric plant being controlled, exemplified in Fig. 3 as a stake P3, that is connected to the ground terminal T of the apparatus 2.

A band-pass filter F, calibrated at the same frequency as the generator G, has in input sinusoidal current 12 collected by a metal stake P2 connected to the terminal DV of the apparatus and of the filter itself and driven into the ground at a depth of between 30 cm and 50 cm and at a distance of 10 m from the stake P3, that absorbs such a current I1 that I2+I1=I.

The current I2 coming from the stake P2 is filtered by the filter F and sent to a current/voltage converter I/V, whose output voltage signal is amplified by a low thermal drift precision amplifier AMP, on which the test button Pt can act. The voltage signal coming from the amplifier AMP is converted into direct voltage signal Vc by the rectifier RAD.

The direct voltage signal Vc is sent to the analog/digital visualizer MD suitable for measuring said signal Vc and visualizing it on the front of the test, measurement and control apparatus 2 (Figures 1 and 2).

The signal Vc can also be converted into digital signal by an analog/digital converter A/D and transmitted by means of modem to a computer.

A comparator TC with variable intervention threshold through the potentiometer TR compares the signal Vc with a reference voltage signal; if the signal Vc is greater than the reference signal, the device TC emits a luminous and/or acoustic alarm signal and can also send a mechanical command signal to the switch 1 to interrupt the electric plant supply. The latter function can be carried out through a relay SM with mechanical blocking system of the current and is enabled and disenabled through the selector switch MA (Figures 1 and 2).

The manual button PT enables intervention on the amplifier AMP to carry out an operational test of the apparatus 2 so as to verify the efficiency of its components and of the electrical and mechanical disengaging command devices connected to it.

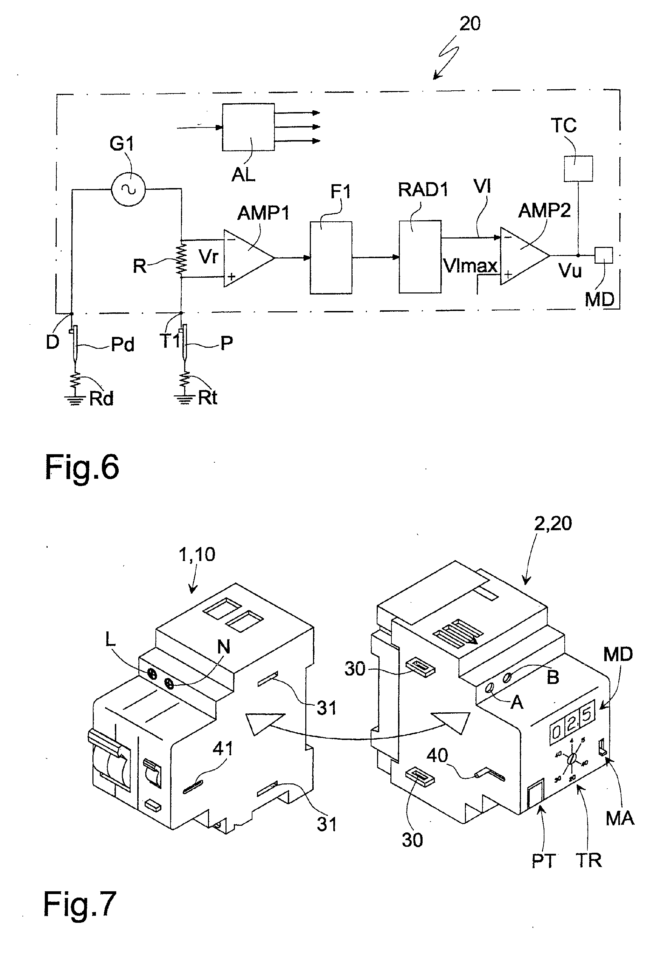

Figure 4 shows a test, measurement and control apparatus according to a second embodiment of the invention, indicated as a whole with 20, that can be associated to a single-phase switch 10 being part of the electric plant, as shown in Figure 5.

The switch 10 can be constituted by a magnetothermal or magnetothermal differential switch (ground fault interrupter device), or by a contactor or other switch device. In the case shown in Figure 5 the switch 10 comprises terminals L and N for a two-wire electric line.

The test apparatus 20 is a two-wire measuring device that is basically similar to the three-wire device 2 previously described. It distinguishes from it by the presence of only two terminals T and R, that can be connected to ground in the manner that will be described below.

The electric block diagram of the apparatus of Figure 4 is shown in Figure 6.

In the circuit of Figure 6 a power supply AL having in input alternating mains voltage (terminals A, B in the Figures 4 and 5) supplies in output the direct voltages needed to supply the circuit components. A sinusoidal current generator G1 supplies voltage at a preset frequency to the terminal D, connected to a stake Pd driven into the ground and having a known resistance Rd (for example 200 ohm), and to the terminal T1, that is connected to the ground plant of the electric plant being controlled, exemplified as stake P.

A differential amplifier AMP1, having inverting and non-inverting inputs connected to the ends of the resistance R, receives a differential voltage Vr, that is amplified, then filtered by a band-pass filter F1 centered on the frequency of the generator G1 and then rectified by a rectifier RAD1 so as to give origin to a voltage V1, which has a maximum value Vlmax when the resistance Rt of the ground stake P is null. A second differential amplifier AMP2 has the voltage V1 on the inverting input and the voltage Vlmax on the non-inverting input; in this manner we achieve in output a voltage Vu directly proportional to the value of the ground resistance Rt. The voltage Vu is used in the same manner as the voltage Vc in output from the circuit of Figure 3, that is, it is sent to the visualizer MD and to the comparator TC, which compares it with a reference voltage. If the voltage Vu is greater than the reference voltage, the device TC emits a luminous or acoustic alarm signal; in addition in these conditions the device TC can send a mechanical command signal to the switch 10 to interrupt the electric plant supply.

Both in the first and in the second embodiment described above the test, measurement and control apparatus of the present invention can be produced integrally with the switch 1 or 10 inside a single container cover (as shown in the Figures 2 and 5) or the apparatus 2 or 20 and the switch 1 or 10 can be separate from each other and positioned in different containing covers as shown in Figure 7. In this case the test measurement and control device 2 or 20 and the switch 1 or 10 are coupled to each other by means of special tabs 30 of the test, measurement and control apparatus 2 or 20 suitable for being inserted in cavity 31 of the switch 1 or 10, as can be seen in Figure 7. In the latter figure components 40 and 41 of the mechanical disengaging and current blocking system, that are commanded by the relay SM of Figure 3 are also represented schematically.

It is to be noted that the test, measurement and control apparatus 2 or 20 measures the efficiency of the ground plant even if current circulates in the electric plant of the building connected to it.

## Claims

1. Test, measurement and control apparatus (2, 20) of a ground plant associated to an electric plant comprising a switch (1, 10) suitable for controlling a supply line of said electric plant, **characterized in that** it comprises at least two terminals (DA, D; DV, T1), of which a first terminal (DA, D) is connected to a first stake (P1, Pd) of conducting material driven into the ground to send it a first signal (I, V) of constant value and a fixed frequency and a second terminal (DV, T1) is connected to a second stake (P2) driven into the ground at a preset distance from the first stake (P1, Pd) and from the ground plant being controlled, or directly to the ground plant, to receive a second signal (I2, Vr) indicative of the state of the ground plant being controlled, and measurement means (TC) suitable for measuring the value of said second signal (12, Vr) and comparing it with a preset threshold.

2. Apparatus according to claim 1, **characterized in that** it comprises signal generating means (G, G1) suitable for supplying said first signal (I, V) to said first terminal (DA, D) and receiving and signal elaborating means (F, I/V, AMP, RAD; AMP1, F1, RAD1, AMP2) suitable for receiving said second signal (I2, Vr) from said second terminal (DV, T1) and converting it into a voltage (Vc, Vu) indicative of the state of the ground plant being controlled, said measurement means (TC) being suitable for measuring the value of said voltage (Vc, Vu) and comparing it with a preset voltage threshold.

3. Apparatus according to claim 2, **characterized in that** said signal generating means (G, G1) comprise constant and fixed frequency sinusoidal signal generator.

4. Apparatus according to claim 2 or 3, **characterized in that** said measurement means (TC) comprise a comparator (TC) suitable for comparing said voltage (Vc, Vu) with a reference voltage and for activating an alarm signal if said voltage (Vc, Vu) exceeds said reference voltage.

5. Apparatus according to claim 4, **characterized in that**, if said voltage (Vc, Vu) exceeds said reference voltage, said comparator (TC) also commands the activation of a command for opening said switch (1, 10).

6. Apparatus according to any of the claims from 2 to 5, **characterized in that** said second terminal (DV) is connected to said second stake (P2) and provision is made for a ground terminal (T) connected to the ground plant being controlled.

7. Apparatus according to claim 6, **characterized in that** said receiving and signal elaborating means (F, I/V, AMP, RAD; AMP1, F1, RAD1, AMP2) comprise a band-pass filter (F) centered on the fixed frequency of said signal generating means (G), a current/voltage converter (I/V), an amplifier (AMP) and a rectifier (RAD).

8. Apparatus according to any of the claims from 2 to 5, **characterized in that** said second terminal (T1) is the ground terminal of the apparatus and is directly connected to the ground plant being controlled.

9. Apparatus according to claim 8, **characterized in that** said receiving and signal elaborating means (F, I/V, AMP, RAD; AMP1, F1, RAD1, AMP2) comprise a first differential amplifier (AMP1) having inverting and non-inverting inputs connected to the ends of a preset resistance (R) placed between said signal generating means (G1) and said second terminal (T1), a band-pass filter (F1) centered on the fixed frequency of said signal generating means (G1), a rectifier (RAD1) and a second differential amplifier (AMP2) suitable for producing said voltage (Vu) indicative of the state of the ground plant being controlled as a difference between an input voltage corresponding to the value of said second signal (Vr) and a reference voltage equal to the maximum value that can be assumed by said input voltage in the case of ground plant with null resistance.

10. Apparatus according to claim 1, **characterized in that** it is inserted in a container separate from that of said switch (1, 10) and hooked to it by connection means (30, 31).

11. Apparatus according to claim 10, **characterized in that** it comprises means (40) for commanding the opening of said switch (1, 10) cooperating with complementary means (41) provided in said switch (1, 10).

12. Apparatus according to claim 1, **characterized in that** it is placed in the same container of said switch (1, 10).

13. Apparatus according to any of the previous claims, **characterized in that** it comprises a manual test button (PT), which when pressed verifies the functionality of the apparatus (2, 20) and triggers the switch (1, 10).
